# EUROPEAN PATENT APPLICATION

(11) **EP 1 111 979 A1**
(43) Date of publication of application: **27.06.2001**
(21) Application number: 99830803.5
(22) Date of filing: 24.12.1999
(51) Int. Cl.: H05K 7/18

(54) **Multistandard cabinet for electronic components**

(71) Applicant: Marconi Communications Network Components & Services - Italia S.p.A., 05100 Terni (IT)
(72) Inventor: Barbarossa, Gino, Marconi Communications, Strada Maratta Bassa Km3695, 05100 Terni (IT); Rinaldi, Bernardino, Marconi Communications, Strada Maratta Bassa Km3695, 05100 Terni (IT)
(74) Representative: Leone, Mario

(57) **Abstract**

A multistandard cabinet for electronic components, apt to contain subracks (10) for supporting electronic cards (20), has a modular and easy to assemble structure, comprising side walls (2) connected to base (3) and cover (4) walls, wherein each of said side walls (2) is obtained from a plane plate and comprises supporting ribs (5, 5') for fastening said subracks (10), located along respective side edges (100,100'), each of such supporting ribs (5,5') being integrally formed with said plate by bending the corresponding side edge (100,100'), such supporting ribs (5,5') defining a first standard insertion width on a first cabinet face (200) , and a second standard insertion width on a opposed second cabinet face (201) for housing subracks (10) of different standards.

## Description

The present invention relates to a multistandard cabinet for electronic components apt to contain supporting subracks for electronic cards.

Various types of subracks for electronic cards are known, each having its own mechanical and/or structural features, but mostly divided according to reference standards identifying some constructive parameters thereof.

One of the differentiating features of those subracks is their width, and more specifically the pitch of the fastening holes which is formed at the front side of the subracks themselves.

Usually, such subracks are removably mounted inside metal cabinets apt to contain them.

Of course, in order to contain a certain subrack type, a cabinet should necessarily comprise supporting means provided inside the cabinet, e.g. on the side walls, thereof, having holes corresponding to the fastening holes provided in the subracks themselves.

Therefore, the above leads to the need to structure "custom-made" cabinets for any type of subrack, particularly those having a different standard width.

Cabinets of this type are known, made of a plurality of parts assembled among them, intended to house a specific subrack type, corresponding to a determined standard width. Such cabinets require that the above mentioned subrack supporting means are obtained according to different modes, and to different sizes determined by the subrack that the cabinet should house.

Therefore, in the assembling step, the cabinet will be provided with supporting means suiting the corresponding subrack.

This necessarily involves the provision of a manufacture step of differentiated supporting means according to the subrack standards, with the entailed burdening of the production and assembly processes, implying a considerable component stockpiling. The mounting, due to its higher complexity, usually has to be carried out directly by the manufacturer rather than by the final user.

Further, each cabinet thus manufactured can merely be used for a single subrack type, thus limiting the system versatility.

The present invention solves such problems of the known art by providing a cabinet as above specified, comprising side walls connected by base and cover walls, characterised in that each of said side walls is obtained from a plane plate and comprises supporting ribs for fastening said subracks, located along respective side edges, each of said supporting ribs being integrally formed with said plate by bending the corresponding side edge, said supporting ribs defining a first standard insertion width on a first cabinet face and a second standard insertion width on a second opposed cabinet face, for housing subracks of different standards.

The main advantage of the present invention is that of providing a multistandard cabinet, i.e. such as to allow the use of subracks corresponding to different width standards, with no need to modify or even replace the cabinet itself. Moreover, precisely due to the peculiar constructive embodiment of the cabinet, making it particularly versatile, subracks of different standards can be concomitantly used.

Another concurrent advantage of the cabinet according to the present invention is provided by the fact that there is no need to distinctly manufacture specific components for the different width standards.

Moreover, a further advantage of the present invention is provided by the extremely simple fastening steps of the various components, that can even be entrusted to the final user, thereby avoiding the problem of having to mount the cabinets in the factory and further easing the transport thereof.

Other advantages, features and uses of the present invention will be made apparent in the following detailed description of one preferred embodiment thereof, given by way of example and not for limitative purposes, making reference to the figures of the annexed drawings, wherein:
figure 1 is a perspective view of a multistandard cabinet for electronic components according to the present invention;
figure 2 is an exploded perspective view of the cabinet of figure 1;
figure 3 is a perspective view of a detail of the cabinet of figure 1; and
figure 4 is a sectional view of the detail of figure 3 along a section line F-F.

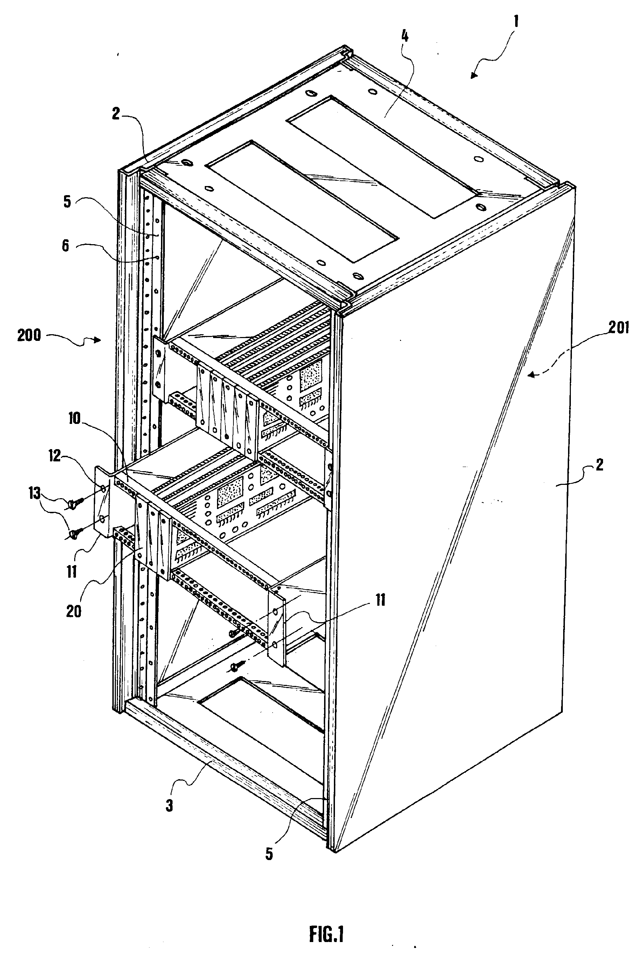

figure 1 is a perspective view of a multistandard cabinet 1 according to the present invention, comprising two side walls 2 connected by a base wall 3 and a cover wall 4.

Two subracks 10 for supporting electronic cards 20 are further shown in the figure, inserted and partially inserted in the cabinet 1.

Along the edges of the side walls 2, the cabinet 1 has supporting ribs 5 that will hereinafter be detailed, apt to allow the fastening of the subracks 10 on the cabinet 1, and the positioning thereof with respect to the whole height of the cabinet itself.

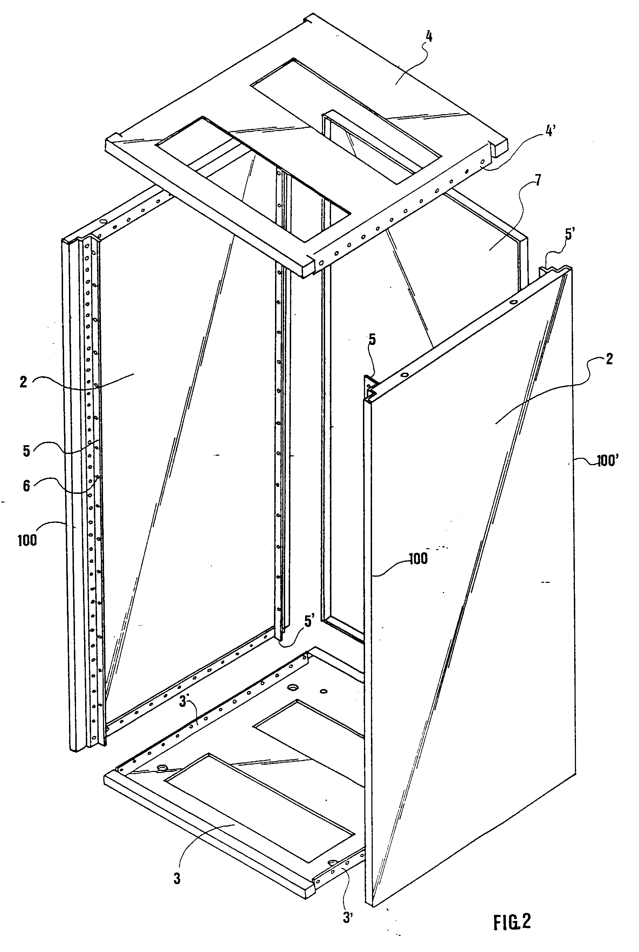

With reference to figure 2, the cabinet 1 according to the present embodiment is made of several components connected among them, e.g., by means of bolts, rivets or other similar devices. Besides the side walls 2, the base wall 3 and the cover wall 4, the cabinet 1 comprises a bottom wall 7 closing one of the two faces 200, 201 of the cabinet. Moreover, one or more hingedly mounted shutting doors, not shown in figure, are provided.

The side walls 2 have a first supporting rib 5 and a second supporting rib, 5', respectively located along first and second opposed side edges, indicated with 100 and 100', respectively.

The supporting ribs 5, 5' are symmetrically positioned therebetween, e.g. at the same distance from the corresponding side edge, yet each having a different transversal extension.

Since the two side walls 2 of the cabinet 1 are equal but specularly located, when the cabinet is mounted, the first supporting ribs 5 of the opposite side walls 2 face each other. The same can be said for the second supporting ribs 5'.

Therefore, the first supporting ribs 5, identifying a first face 200 of the cabinet onto which they are located, define a first standard width of the opening between the side walls 2 for the insertion of a respective subrack 10.

Analogously, the second supporting ribs 5', located at a second face 201, define a second standard width of the opening between the side walls 2 for the insertion of a subrack 10 manufactured according to a standard differing from the former. For this purpose, such supporting ribs 5 have positioning means apt to fasten the subracks 10, in the present embodiment comprising a plurality of holes 6 to which respective through holes 12, obtained on side fastening ribs 11 of the subrack 10, correspond. Such holes 6 are obtained in order to lock up respective nuts, inside of which a threaded seat is provided for housing the bolts 13, apt to correctly fasten the subrack 10 itself.

Of course, further embodiments of the cabinet can be provided, in which said positioning means are obtained with different locking systems, e.g. bayonet, ratchet or screw systems, commonly known to a person skilled in the art.

Each side edge 100, 100' of the side wall 2 comprises a plurality of strip bendings connecting the respective supporting rib 5,5' to the side wall 2 and supporting the bottom wall 7 and the shutting doors.

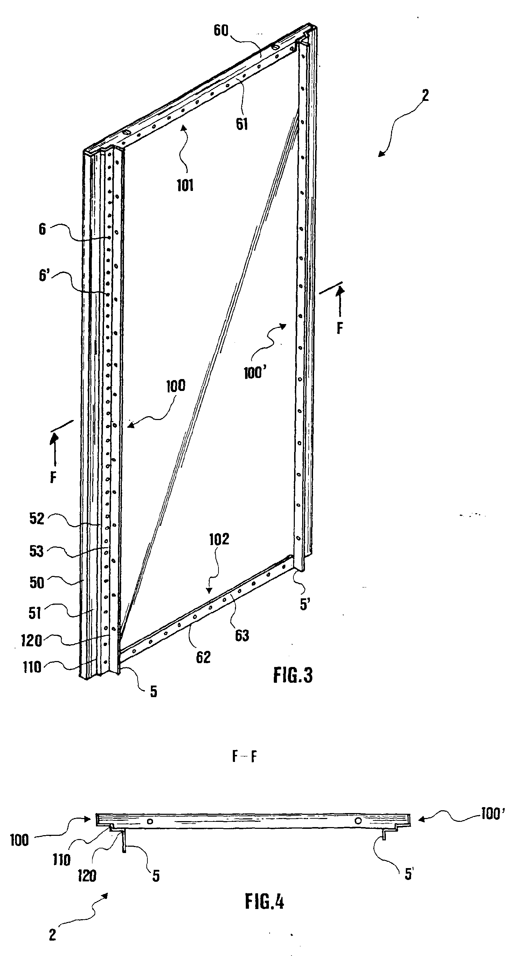

With particular reference to figures 3 and 4, the supporting rib 5 as well as the additional strip bendings are obtained with bending steps of the plane plate constituting the side wall 2. In particular, a first 90° bending connects the plate to a first strip bending 50, that in turn is connected toward the centre of the plate to a second strip bending 51. A third strip bending 52 is connected to the former by a 90° bending, obtaining a stepped configuration, followed by an analogously connected fourth strip bending 53. The respective first or second supporting ribs 5, 5' is connected to the fourth strip bending 53.

The second and the third strip bending 51, 52, form a first recess 110 apt to house the bottom wall 7. Thus the bottom wall can be fastened to the cabinet with bolts tightenable onto the already described corresponding holes 6 on the supporting ribs 5, 5', obviously on the cabinet 1 portion, without inserting subracks 10 therethrough.

The fourth strip bending 53 and the respective supporting ribs 5, 5' connected thereto, instead define a second recess 120, apt to house the hinges of the above mentioned doors and possible projections of the subracks, like e.g., handles for the insertion or lifting thereof from the cabinet itself. Such second recess 120 is provided with holes 6', located in preset positions along the whole extension of the second recess 120, apt to fasten the hinges. Further, such holes 6' can also be used for fastening the bottom wall 7 with suitable connecting squares.

Said first and second recess 110, 120 are symmetrically obtained at both said first and second edge 100, 100', so that the first recess on both the edges 100, 100' may house the same bottom wall 7 format.

The base 3 and cover 4 walls, are obtained machining a distinct plane metal plate, by drilling and edge bending in order to obtain fastening means of such walls 3,4 to the side walls 2 of the cabinet 1 itself.

An upper edge 101, obtained by plate bending and provided with holes, is made onto the upper portion of the side wall 2 as well, so as to obtain first and second bent sections, indicated with 60 and 61 respectively. These first and second bent sections 60, 61, are such to cooperate with respective bent sections 4' obtained by bending the cover wall 4.

Likewise, third and fourth bent sections 62, 63 and fastening holes are provided also at the lower portion of the side wall 2 on a lower edge 102, in order to match respective bent sections 3' obtained by bending the base wall 3.

Obviously, the number, the shape and the dimensions of the hereto disclosed ribs and bent sections, as well as the number and the position of the various fastening holes hereto provided may vary according to the constructive requirements.

The above disclosed structure allows the use, even concomitantly, of subracks 10 of two distinct standard widths. In fact, since the presence of the bottom wall 7 is not strictly necessary, advantageously such cabinet can concomitantly contain subracks belonging to a first width standard as well as subracks belonging to a second width standard, insertable from different faces of the same cabinet.

In this case, as mentioned above, the bottom wall cannot be mounted, whereas shutting doors can possibly be mounted onto both the cabinet faces 200,201.

Advantageously, the base wall 3 and the cover wall 4 are equal and symmetrically located therebetween. Therefore, besides the non-essential shutting doors and bottom wall 7, the cabinet 1 merely requires two components for the construction of its structure: a pair of side walls 2 and a pair of base/cover walls 3,4, plus the required fastening devices.

These components, plus the above mentioned non-essential ones, can be assembled according to a simple and self-explanatory edge-to-edge assembly, merely requiring simple assembly tools, e.g. screwdrivers, wrenches and riveter, not entailing the connection of plane components requiring more complex assembly systems like welding.

Therefore, the cabinet can be provided to the users as an assembly kit, comprising a pair of side walls 2 as above disclosed; a pair of base/cover walls 3, 4; and fastening devices.

Possibly, such kit can provide a bottom wall 7 and shutting doors, optionally provided with hinges.

Summing up, all of those components can be manufactured from suitably trimmed, drilled, cold-bent and possibly galvanised or painted plane plates.

The present invention was hereto disclosed according to a preferred embodiment thereof, given by way of example and not for limitative purposes.

It is understood that other embodiments of the same invention may be provided, all however comprised within the protective scope of the present invention, as defined by the annexed claims.

## Claims

1. A multistandard cabinet for electronic components, apt to contain subracks (10) for supporting electronic cards (20), comprising side walls (2) connected with base (3) and cover (4) walls, characterised in that each of said side walls (2) is obtained from a plane plate and comprises supporting ribs (5, 5') for fastening said subracks (10), located along respective side edges (100,100'), each of said supporting ribs (5, 5') being integrally formed with said plane by bending the corresponding side edge (100, 100') thereof, said supporting ribs (5, 5') defining a first standard insertion width on a first cabinet face (200), and a second standard insertion width on a second opposed cabinet face (201), for housing subracks (10) having different standards.

2. The multistandard cabinet according to claim 1, wherein said side walls are equal and specularly located.

3. The multistandard cabinet according to claim 1 or 2, wherein said plate is a metal sheet.

4. The multistandard cabinet according to any one of the preceding claims, wherein said supporting ribs (5,5') are located perpendicularly to said side walls (2).

5. The multistandard cabinet according to any one of the preceding claims, wherein said supporting ribs (5,5') comprise positioning means (6) apt to fasten said subracks (10) in preset positions inside said cabinet.

6. The multistandard cabinet according to claim 5, wherein said positioning means comprise a plurality of holes (6) located along said supporting ribs (5,5'), such holes (6) being equally spaced among them.

7. The multistandard cabinet according to claim 6, wherein each hole(6) of said plurality of holes locks up a respective nut apt to engage a corresponding bolt (13) in its own seat.

8. The multistandard cabinet according to any one of the preceding claims, wherein each of said side walls (2) has, at each side edge (100,100') thereof, a plurality of strip bendings (50,51,52,53) apt to connect a respective supporting rib (5,5') to said side wall (2).

9. The multistandard cabinet according to claim 8, wherein said plurality of strip bendings (50,51,52,53) comprises:
- a first strip bending (50), connected to said side wall (2) and perpendicular thereto;
- a second strip bending (51), connected to said first strip bending (50) and perpendicular thereto;
- a third strip bending (52), connected to said second strip bending (51) and perpendicular thereto; and
- a fourth strip bending (53) connected to said third strip bending (52) and perpendicular thereto,
said second and third strip bending (51, 52) forming a first recess (110) apt to house a corresponding edge of a bottom wall (7) and said fourth strip bending (53) and said supporting rib (5,5') defining a second recess (120) apt to house hinges of a door and projections of said subracks (10) .

10. The multistandard cabinet according to claim 9, wherein said first and second recess (110,120) are symmetrically obtained at the respective side edges (100,100') of said side wall (2) .

11. The multistandard cabinet according to any one of the preceding claims, wherein said side walls (2) and said base (3) and cover (4) walls comprise fastening means (60,61,62,63,3',4') apt to removably fasten said base (3) and cover (4) walls.

12. The multistandard cabinet according to claim 11, characterised in that said fastening means (60,61,62,63,3',4') comprise first and second bent sections (60,61), apt to cooperate with respective sections (3') obtained by bending said base walls (3) and third and fourth bent sections (62,63), apt to cooperate with respective sections (4') obtained by bending said cover walls (4).

13. A side wall of a multistandard cabinet for electronic components (1), characterised in that it is obtained from a plane metal sheet and comprising supporting ribs (5, 5') for fastening subracks (10) for supporting electronic cards (20), located along respective side edges (100,100'), each of said supporting ribs (5,5') being integrally formed with said metal sheet by bending the corresponding side edge (100,100'), said supporting ribs (5,5') defining a first standard insertion width on a first face (200) of the cabinet (1) and a second standard insertion width on a opposed second face (201) of the cabinet (1), for housing subracks (10) of different standards.

14. The side wall according to claim 13, wherein said supporting ribs (5,5') are located perpendicularly to said side wall (2).

15. The side wall according to claim 13 or 14, wherein said supporting ribs (5,5') comprise positioning means (6) apt to fasten said subracks (10) in preset positions inside said cabinet (1).

16. The side wall according to claim 15, wherein said positioning means comprise a plurality of holes (6) located along said supporting ribs (5,5'), such holes (6) being equally spaced among them.

17. The side wall according to claim 16, wherein each hole (6) of said plurality of holes locks up a respective nut, apt to engage a corresponding bolt (13) in the seat thereof.

18. The side wall according to any one of the claims 13 to 17, having, at each side edge (100,100'), a plurality of strip bendings (50,51,52,53) apt to connect a respective supporting rib (5,5') to said side wall (2).

19. The side wall according to claim 18, wherein said plurality of strip bendings (50,51,52,53) comprises:
- a first strip bending (50), connected to said side wall (2) and perpendicular thereto;
- a second strip bending (51), connected to said first strip bending (50) and perpendicular thereto;
- a third strip bending (52), connected to said second strip bending (51) and perpendicular thereto; and
- a fourth strip bending (53) connected to said third strip bending (52) and perpendicular thereto,
said second and third strip bending (51, 52) forming a first recess (110) apt to house the corresponding edge of a bottom wall (7) and said fourth strip bending (53) and said supporting rib (5,5') defining a second recess (120) apt to house hinges of a door and projections of said subracks (10) .

20. An assembly kit of a multistandard cabinet for electronic components, comprising: a pair of side walls (2) according to any one of the claims 13 to 19; a base wall (3); a cover wall (4); and suitable fastening means.

21. The kit according to claim 20, wherein the base wall (3) and the cover wall (4) are equal.

22. The kit according to claim 20 or 21, comprising a bottom wall (7) and/or shutting doors.
